(19) Europäisches Patentamt
European Patent Office
Office européen des brevets

(11) **EP 4 641 182 A1**

(12) **EUROPEAN PATENT APPLICATION**
published in accordance with Art. 153(4) EPC

(43) Date of publication:
**29.10.2025 Bulletin 2025/44**

(21) Application number: 23943395.6

(22) Date of filing: **08.12.2023**

(51) International Patent Classification (IPC):
**G01N 23/04** (2018.01)   **G01N 23/083** (2018.01)

(52) Cooperative Patent Classification (CPC):
**G01N 21/01; G01N 21/88; G01N 21/95;**
**G01N 23/04; G01N 23/083; G01R 31/36**

(86) International application number:
**PCT/CN2023/137468**

(87) International publication number:
**WO 2025/000920 (02.01.2025 Gazette 2025/01)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **30.06.2023 CN 202321704318 U**

(71) Applicant: **Contemporary Amperex Technology Co., Limited**
**Ningde, Fujian 352100 (CN)**

(72) Inventors:
• **SHI, Zhimeng**
**Ningde, Fujian 352100 (CN)**
• **ZHANG, Tao**
**Ningde, Fujian 352100 (CN)**
• **ZHANG, Fenglin**
**Ningde, Fujian 352100 (CN)**
• **LIU, Jianlin**
**Ningde, Fujian 352100 (CN)**

(74) Representative: **von Tietzen und Hennig, Nikolaus**
**Lorenz Seidler Gossel**
**Rechtsanwälte Patentanwälte**
**Partnerschaft mbB**
**Widenmayerstraße 23**
**80538 München (DE)**

(54) **BATTERY INSPECTION DEVICE**

(57)   The present application provides a battery inspection device, and belongs to the technical field of batteries. The battery inspection device comprises a bearing assembly, an X-ray source, and a flat panel detector; the bearing assembly is used for bearing a battery under test; the X-ray source is used for irradiating X-rays to the battery under test on the bearing assembly; and the flat panel detector and the X-ray source are each located on one side of the bearing assembly, and the flat panel detector is used for receiving rays that are emitted by the X-ray source and penetrate through the battery under test.

FIG. 1

## Description

### CROSS-REFERENCE

The present application refers to the Chinese Patent Application No. 202321704318.9 entitled "BATTERY DETECTION DEVICE", filed on June 30, 2023, which is incorporated herein by reference in its entirety.

### TECHNICAL FIELD

The present application relates to the technical field of batteries, and in particular, to a battery detection device.

### BACKGROUND

Energy conservation and emission reduction are the key to sustainable development of the automobile industry. Electric vehicles have become an important part of the sustainable development of the automobile industry due to their energy-saving and environmental protection advantages. For electric vehicles, the battery technology is an important factor in their development.

Various internal defects may be generated in the production process of the battery, and these internal defects can affect the quality and safety of the battery. At present, the detection of internal defects of the battery is usually completed by manually observing the appearance, and the reliability, stability and efficiency of the detection cannot be effectively controlled.

### SUMMARY

The present application aims to solve at least one of the technical problems existing in the background. Therefore, an objective of the present application is to provide a battery detection device, so as to improve the efficiency of battery defect detection.

Embodiments of the present application provide a battery detection device, which includes: a carrying assembly, an X-ray source, and a flat panel detector. The carrying assembly is configured to carry a battery to be detected, and the X-ray source is configured to irradiate X-rays to the battery to be detected on the carrying assembly. The flat panel detector and the X-ray source are respectively located on two sides of the carrying assembly, and the flat panel detector is configured to receive rays emitted by the X-ray source and penetrating through the battery to be detected.

In the technical solutions of the embodiments of the present application, the battery to be detected is disposed on the carrying assembly, and the flat panel detector and the X-ray source are respectively located on two sides of the carrying assembly. The X-ray source irradiates the X-rays to the battery to be detected, and the flat panel detector receives the X-rays emitted by the X-ray source and penetrating through the battery to be detected, and performs imaging based on the X-rays. Because different materials have different absorption rates for the X-rays, various defects of the battery to be detected will appear in the detection image of the battery to be detected, which is acquired by the flat panel detector receiving the X-rays penetrating through the battery to be detected. Therefore, the efficiency of battery defect detection can be effectively improved, and the outflow of risky products can be prevented.

In some embodiments, a focal spot size L1 of the X-ray source satisfies: $L1 \leq 80 \ \mu m$. The dimension of the focal spot size L1 of the X-ray source is directly related to the image resolution of the battery detection device. Specifically limiting the dimension of the focal spot size L1 of the X-ray source can better match the detection precision of the battery detection device with the size of the defect in the detected battery to be detected, thereby improving the accuracy and efficiency of the detection.

In some embodiments, the focal spot size L1 of the X-ray source satisfies: $30 \ \mu m \leq L1 \leq 80 \ \mu m$. By limiting the focal spot size L1 of the X-ray source to satisfy: $30 \ \mu m \leq L1 \leq 80 \ \mu m$, the service life of the X-ray source can be prolonged while the accuracy and efficiency of the detection are improved.

In some embodiments, the focal spot size L1 of the X-ray source satisfies: $40 \ \mu m \leq L1 \leq 70 \ \mu m$. By limiting the focal spot size L1 of the X-ray source to satisfy: $40 \ \mu m \leq L1 \leq 70 \ \mu m$, the accuracy and efficiency of the detection can be further improved while the service life of the X-ray source can be further prolonged.

In some embodiments, the focal spot size L1 of the X-ray source satisfies: $50 \ \mu m \leq L1 \leq 60 \ \mu m$. By limiting the focal spot size L1 of the X-ray source to satisfy: $50 \ \mu m \leq L1 \leq 60 \ \mu m$, the accuracy and efficiency of the detection can be still further improved while the service life of the X-ray source can be still further prolonged.

In some embodiments, the power P of the X-ray source satisfies: $65 \ W \leq P \leq 75 \ W$. Limiting the power P of the X-ray source to $65 \ W \leq P \leq 75 \ W$ can to a certain extent improve the resolution of the flat panel detector, and meanwhile, can to a certain extent improve the brightness of the detection image, thereby improving the accuracy of the detection.

In some embodiments, the power P of the X-ray source satisfies: $68 \ W \leq P \leq 72 \ W$. Further limiting the power P of the X-ray source to $68 \ W \leq P \leq 72 \ W$ can further improve the resolution of the flat panel detector, and meanwhile, can further improve the brightness of the detection image, thereby improving the accuracy of the detection device.

In some embodiments, the operating voltage V of the X-ray source satisfies: $V \geq 130 \ kV$, and/or the operating current I of the X-ray source satisfies: $I \leq 500 \ \mu A$. By limiting the operating voltage V and the operating current I of the X-ray source, the stability and reliability of the X-ray source can be taken into account on the basis that the X-ray dose that meets the requirements is provided. Meanwhile, the X-ray source and the flat panel detector cooperate with each other, and the requirements for the detection precision of the battery to be detected are met, and the efficiency and accuracy of the detection are improved.

In some embodiments, the operating voltage V of the X-ray source satisfies: $V \geq 150$ kV, and/or the operating current I of the X-ray source satisfies: $I \leq 400$ $\mu$A. By further limiting the operating voltage V or the operating current I of the X-ray source, the X-ray dose emitted by the X-ray source is further improved. Meanwhile, the stability and reliability of the X-ray source are further improved, and the efficiency and accuracy of the detection are improved.

In some embodiments, the flat panel detector is an amorphous silicon flat panel detector. By using the amorphous silicon flat panel detector as the flat panel detector of the battery detection device, the detection efficiency of the battery detection device can be improved and the service life of the battery detection device can be prolonged.

In some embodiments, a pixel size L2 of the flat panel detector satisfies: $L2 \leq 100$ $\mu$m. By limiting the pixel size L2 of the flat panel detector, the requirements for the detection precision of the battery to be detected can be met while the efficiency and accuracy of the detection can also be improved.

In some embodiments, the pixel size L2 of the flat panel detector satisfies: $30$ $\mu$m $\leq L2 \leq 90$ $\mu$m. By further limiting the pixel size L2 of the flat panel detector, the requirements for the detection precision of the battery to be detected are met while the efficiency and accuracy of the detection are further improved.

In some embodiments, the pixel size L2 of the flat panel detector satisfies: $70$ $\mu$m $\leq L2 \leq 80$ $\mu$m. By still further limiting the pixel size L2 of the flat panel detector, the efficiency and accuracy of the detection are still further improved.

In some embodiments, in a first direction, the distance h1 between the X-ray source and a carrying surface of the carrying assembly and the distance h2 between the carrying surface of the carrying assembly and the flat panel detector satisfy the relationship: $(h1 + h2)/h1 \leq 2.5$, where the first direction is the direction perpendicular to the principal plane of the flat panel detector. By limiting the relationship between the distance between the X-ray source and the carrying surface of the carrying assembly and the distance between the carrying surface of the carrying assembly and the flat panel detector, the detection precision of the battery detection device can better match with the size of the flat panel detector while the accuracy and efficiency of the detection can be improved.

In some embodiments, the distance h1 between the X-ray source and the carrying surface and the distance h2 between the carrying surface and the flat panel detector satisfy the relationship: $1.5 \leq (h1 + h2)/h1 \leq 2.0$. By further limiting the relationship between the distance between the X-ray source and the carrying surface of the carrying assembly and the distance between the carrying surface of the carrying assembly and the flat panel detector, the detection precision of the battery detection device can further better match with the size of the flat panel detector while the accuracy and efficiency of the detection can be further improved.

The above description is only an overview of the technical solutions of the present application. To more clearly understand the technical means of the present application to enable implementation in accordance with the content of the specification and to make the above and other purposes, features, and advantages of the present application more obvious and easy to understand, the detailed description of the present application is provided below.

BRIEF DESCRIPTION OF THE DRAWINGS

In the accompanying drawings, unless otherwise specified, the same reference numerals across multiple accompanying drawings indicate the same or similar components or elements. The accompanying drawings are not necessarily drawn to scale. It should be understood that the accompanying drawings depict only some embodiments of the present application and are therefore not to be considered as limiting the scope of the present application. To more clearly illustrate the technical solutions in the embodiments of the present application, the drawings required for illustrating the embodiments of the present application are briefly described below. Apparently, the drawings in the following description illustrate merely some embodiments of the present application, and those of ordinary skills in the art may still derive other drawings from these drawings without creative efforts.

FIG. 1 is a structural schematic view of a battery detection device according to some embodiments of the present application;

FIG. 2 is an imaging schematic view of a battery detection device according to some embodiments of the present application;

FIG. 3 is a structural schematic view of a battery detection device according to some other embodiments of the present application;

FIG. 4 is a flowchart of a detection method of a battery detection device according to some embodiments of the present application;

FIG. 5 is a schematic view of a detection image of a battery to be detected according to some embodiments of the present application; and

FIG. 6 is a schematic view of a detection image of a battery to be detected according to some other embodiments of the present application.

Description of the reference numerals:
100, battery detection device; 110, carrying assembly; 120, X-ray source; 130, flat panel detector; 140, battery to be detected.

DETAILED DESCRIPTION

Embodiments of the technical solutions of the present application will be described in detail below with reference to the drawings. The following embodiments are only used to more clearly illustrate the technical solutions of the present application, and therefore, are only exemplary and do not limit the claimed scope of the present application.

Unless otherwise defined, all technical and scientific terms used herein have the same meaning as commonly understood by those skilled in the technical field to which the present application belongs. The terms used herein are only used to illustrate the specific embodiments, rather than limit the present application. The terms "include", "comprise", and "provided with", and any variations thereof in the description and claims of the present application and the above drawing description encompass non-exclusive inclusions.

In the description of the embodiments of the present application, technical terms such as "first", "second", and the like are only used to distinguish different objects and should not be interpreted as indicating or implying the relative importance or implicitly indicating the number, specific order, or primary and secondary relationship of the noted technical features. In the description of the embodiments of the present application, unless otherwise specifically defined, "plurality of" means two or more.

Reference in the present application to "embodiment" means that a particular feature, structure, or characteristic described in combination with the embodiment can be included in at least one embodiment of the present application. The references of the word in the context of the specification do not necessarily refer to the same embodiment, nor to separate or alternative embodiments exclusive of other embodiments. It will be explicitly and implicitly appreciated by those skilled in the art that the embodiments described herein can be combined with other embodiments.

In the description of the embodiments of the present application, the term "and/or" is merely a way to describe the associative relationship between associated objects, indicating that there are three possible relationships. For example, "A and/or B" may denote: the presence of A alone, the simultaneous presence of A and B, and the presence of B alone. In addition, the character "/" herein generally indicates an "or" relationship between the associated objects before and after the "/".

In the description of the embodiments of the present application, the term "plurality of" refers to two or more (including two). Similarly, "plurality of groups" refers to two or more (including two) groups, and "plurality of pieces" refers to two or more (including two) pieces.

In the description of the embodiments of the present application, the technical terms "center", "longitudinal", "transverse", "length", "width", "thickness", "upper", "lower", "front", "rear", "left", "right", "vertical", "horizontal", "top", "bottom", "inner", "outer", "clockwise" "counterclockwise", "axial", "radial", "circumferential" and the like indicate orientations or positional relationships based on those shown in the drawings. They are merely for the convenience of describing the present application and simplifying the description, rather than indicating or implying that the device or element referred to must have a specific orientation or be constructed and operated in the specific orientation, and thus should not be construed as a limitation to the present application.

In the description of the embodiments of the present application, unless otherwise clearly specified and defined, the technical terms "mount", "interconnect", "connect", "fix", and the like should be interpreted in their broad senses. For example, they may be a fixed connection, a detachable connection, or an integral connection; a mechanical connection or an electrical connection; or a direct connection, an indirect connection via an intermediate, a communication between interiors of two elements, or an interaction between two elements. For those of ordinary skill in the art, the specific meanings of the above terms in the embodiments of the present application can be interpreted according to specific conditions.

At present, judging from the trends in the market, the application of power batteries is becoming increasingly widespread. Power batteries are not only applied in energy storage power systems such as hydropower, thermal power, wind power, and solar power stations, but are also widely applied in electric transportation vehicles such as electric bicycles, electric motorcycles, or electric cars, as well as in military equipment, aerospace, and other fields. With the continuous expansion of the application field of power batteries, the market demand for power batteries is also constantly increasing.

In the production process of power batteries, because of a large number of mechanical devices on the production line, metal chips are very easily generated due to mechanical wear. In addition, because part of the processes of battery production are related to cutting and welding, metal chips are more easily generated, and these metal chips fall into the interior of the housing of the battery, which may pose risks to the battery. For example, when the metal chips reach a certain size, the sharp metal chips may puncture the separator, which causes the battery to self-discharge. The metal chips may also puncture the blue film, which causes a short circuit between adjacent battery cells included in the battery, thereby posing safety risks to the battery.

At present, metal chips falling into the interior of the housing of the battery are reduced by additionally mounting a ventilation and dust suction device, welding and dispensing, and the like in the production process of batteries. However, these methods cannot completely eliminate the metal chips, and the risk of the outflow of defective batteries still exists.

In order to further reduce the risk of the outflow of defective batteries, sampling detection is performed on batteries by means of computed tomography (CT). However, this method takes a relatively long imaging time and has an extremely low efficiency, so that the full detection of products cannot be realized.

Based on this, it is necessary to provide a battery detection device, to improve the efficiency of battery defect detection.

The battery detection device disclosed in the embodiments of the present application is applicable to battery cells and finished batteries, and is applicable to, but not limited to, the detection procedures in the production and manufacturing process of batteries.

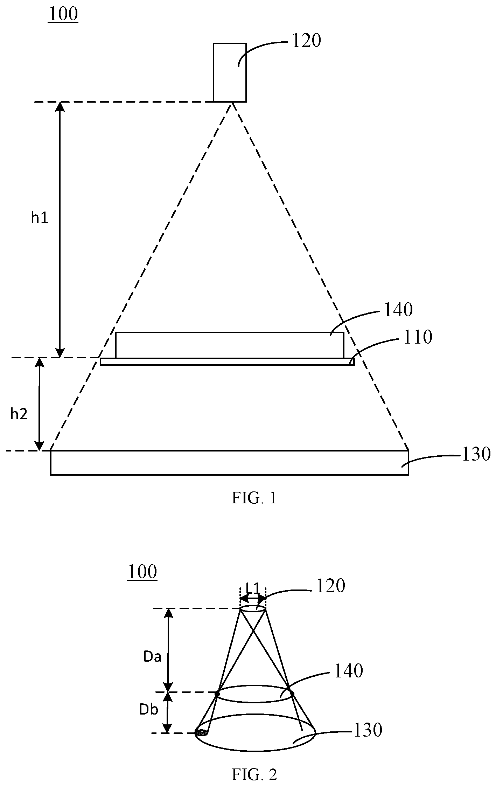

FIG. 1 is a structural schematic view of a battery detection device 100 according to some embodiments of the present application. As shown in FIG. 1, the battery detection device 100 includes a carrying assembly 110, an X-ray source 120, and a flat panel detector 130.

The carrying assembly 110 is configured to carry a battery 140 to be detected, and the X-ray source 120 is configured to irradiate X-rays to the battery 140 to be detected on the carrying assembly 110. The flat panel detector 130 and the X-ray source 120 are respectively located on two sides of the carrying assembly 110. The flat panel detector 130 is configured to receive the rays emitted by the X-ray source 120 and penetrating through the battery 140 to be detected.

In some embodiments of the present application, the carrying assembly 110 may be any carrying structure, such as a tray or a clamping jaw, and may fix the battery 140 to be detected in a carrying or clamping manner. The carrying assembly 110 may be fixed or movable. For example, a tray or a clamping mechanism that is provided with a conveying track and moves along the conveying track can sequentially convey the battery 140 to be detected to the detection station, and remove the battery 140 to be detected after the detection is completed. The number of the battery 140 to be detected carried on the carrying assembly 110 may be one or more. In one example, the carrying assembly 110 may include a plurality of trays, and each tray carries one or more batteries 140 to be detected. The battery 140 to be detected may be a battery cell, or a battery including a plurality of battery cells, and may be a prismatic battery, a cylindrical battery, a special-shaped battery, or the like.

In some embodiments of the present application, the flat panel detector 130 is a device capable of converting the received X-ray energy into a recordable electric signal, and may be composed of three parts: an X-ray conversion module, a photoelectric conversion module, and a signal readout and transmission module. After receiving the X-rays with different intensities, the flat panel detector 130 may correspondingly generate the electric signal proportional to the intensity of the X-rays. Therefore, the flat panel detector 130 can acquire internal structure information of an object penetrated by the X-rays, and transmit the internal structure information of the object into the processor in the form of a grayscale image, thereby detecting the object.

In some embodiments of the present application, the flat panel detector 130 is a two-dimensional flat panel detector, and the flat panel detector 130 may be an indirect flat panel detector or a direct flat panel detector. The flat panel detector 130 is an imaging device for the X-rays. During the process in which the battery detection device 100 detects the battery 140 to be detected, the battery 140 to be detected is located on the carrying assembly 110 and is located in the radiation area of the X-rays of the X-ray source 120. The X-rays emitted by the X-ray source 120 are projected to the flat panel detector 130 after penetrating through the battery 140 to be detected. The flat panel detector 130 receives the X-rays penetrating through the battery 140 to be detected, and images the battery 140 to be detected to acquire the detection image of the battery 140 to be detected.

In some embodiments of the present application, the X-ray source 120 may be open (an open tube) or may be closed (a closed tube). The X-rays emitted by the X-ray source 120 will be absorbed and attenuated by the battery 140 to be detected when penetrating through the battery 140 to be detected. Since the materials of a cathode electrode plate and an anode electrode plate in the battery 140 to be detected, and the metal chips that may exist inside the battery are different, different materials have different absorption rates for the X-rays (the surface of the anode electrode plate is made of carbon powder, which has weak absorption of the X-rays; the surface of the cathode electrode plate is made of a lithium-ion material, which has strong absorption of the X-rays; and the metal chips have stronger absorption of the X-rays). In addition, materials with different thicknesses have different absorption rates for the X-rays, and the thicker the material is, the greater the absorption of the X-rays by the material is. Therefore, various defects of the battery 140 to be detected will appear in the detection image of the battery 140 to be detected, which is acquired by the flat panel detector 130 receiving the X-rays penetrating through the battery 140 to be detected. Thus, the defect detection of the battery 140 to be detected can be performed through the detection image of the battery 140 to be detected.

According to the embodiments of the present application, the battery 140 to be detected is disposed on the carrying assembly 110, and the flat panel detector 130 and the X-ray source 120 are respectively located on two sides of the carrying assembly 110. The X-ray source 120 irradiates the X-rays to the battery 140 to be detected, and the flat panel detector 130 receives the X-rays emitted by the X-ray source 120 and penetrating through the battery 140 to be detected, and performs imaging based on the X-rays. Because different materials have different absorption rates for the X-rays, various defects of the battery 140 to be detected will appear in the detection image of the battery 140 to be detected, which is acquired by the flat panel detector 130 receiving the X-rays penetrating through the battery 140 to be detected. Therefore, the efficiency of battery defect detection can be effectively improved, and the outflow of risky products can be prevented.

According to some embodiments of the present application, the focal spot size L1 of the X-ray source 120 satisfies: L1 ≤ 80 micrometers ($\mu$m).

In some embodiments of the present application, the X-rays emitted by the X-ray source 120 are cone-shaped beams, and a certain focal spot size of the X-ray source 120 cannot be equivalent to a point light source. Therefore, when the battery detection device 100 is used to perform the defect detection on the battery 140 to be detected, the imaging end of the battery 140 to be detected may be affected by the focal spot size of the X-ray source 120. The larger the focal spot size of the X-ray source 120 is, the less clear the detection image of the battery 140 to be detected is. The size of the defect in the battery 140 to be detected is generally relatively small, and smaller defects are more susceptible to imaging unclarity. Using an X-ray source 120 with a smaller focal spot size is more conducive to defect identification.

In some embodiments of the present application, the focal spot size of the X-ray source 120 refers to the size of the focal spot in a certain direction parallel to a plane where the focal spot is located. In the case where other conditions are consistent, the smaller the focus is, the higher the resolution is, and the better the imaging quality is. Common methods for measuring the focal spot size of the X-ray source 120 are classified into a direct method and an indirect method. The direct method refers to directly observing the shape and size of the focal spot, such as a pinhole method. The indirect method refers to calculating the focal spot size by observing a point spread function or a line spread function caused by the focal spot size, and this method includes a knife-edge method, a slit method, and a spherical target method. Detection can also be performed with reference to methods specified in relevant measurement standards, such as the measurement methods listed in GB/T26834-2011.

Illustratively, FIG. 2 is an imaging schematic view of a battery detection device 100 according to some embodiments of the present application. As shown in FIG. 2, the distance between an X-ray source 120 and a carrying assembly 110 is Da, and the distance between the carrying assembly 110 and a flat panel detector 130 is Db (the distance between a battery 140 to be detected and the flat panel detector 130 may be approximately Db), and the focal spot size of the X-ray source 120 is L1. The unclarity of an image on the flat panel detector 130 is U, where U = (L1 × Db)/Da. The magnification of the battery 140 to be detected on the flat panel detector 130 is M, where M = (Da + Db)/Da. Due to the limited imaging area of the flat panel detector 130, when the battery detection device 100 is used to detect the battery 140 to be detected, the magnification M of the battery 140 to be detected generally does not exceed 2.5 times, that is, M ≤ 2.5, and the actual image of metal particles of 500 $\mu$m is at most 500 × M = 1250 $\mu$m.

Further, in order to facilitate the identification of the defect in the battery 140 to be detected, the unclarity U of the image of the metal particles generally needs to be less than 1/10 of the actual image size, that is, U = 1250 $\mu$m/10 ≤ 125 $\mu$m. In addition, because (Da + Db)/Da = M ≤ 2.5, combined with U = (L1 × Db)/Da, the focal spot size satisfies L1 ≤ 83 $\mu$m. Considering the scattering of X-ray photons and leaving some design redundancy, the X-ray source 120 with the focal spot size L1 ≤ 80 $\mu$m is selected optimally.

According to the embodiments of the present application, the dimension of the focal spot size L1 of the X-ray source 120 is directly related to the image resolution of the battery detection device 100. Specifically limiting the dimension of the focal spot size L1 of the X-ray source 120 can better match the detection precision of the battery detection device 100 with the size of the defect in the detected battery 140 to be detected, thereby improving the accuracy and efficiency of the detection.

According to some embodiments of the present application, the focal spot size L1 of the X-ray source 120 satisfies: 30 $\mu$m ≤ L1 ≤ 80 $\mu$m.

In some embodiments of the present application, a large amount of heat is generated while the X-ray source 120 emits the X-rays, and the temperature rises sharply. Based on the perspective of the heat dissipation of the X-ray source 120, the larger the focal spot size L1 of the X-ray source 120 is, the easier the heat dissipation of the X-ray source 120 is, thereby prolonging the service life of the X-ray source 120. Therefore, the focal spot size L1 of the X-ray source 120 should not be too small.

In the embodiments of the present application, by limiting the focal spot size L1 of the X-ray source 120 to satisfy: 30 $\mu$m ≤ L1 ≤ 80 $\mu$m, the service life of the X-ray source 120 can be prolonged while the accuracy and efficiency of the detection are improved.

According to some embodiments of the present application, the focal spot size L1 of the X-ray source 120 satisfies: 40 $\mu$m ≤ L1 ≤ 70 $\mu$m.

In the embodiments of the present application, by limiting the focal spot size L1 of the X-ray source 120 to satisfy: 40 $\mu$m ≤ L1 ≤ 70 $\mu$m, the accuracy and efficiency of the detection can be further improved while the service life of the X-ray source 120 can be further prolonged.

According to some embodiments of the present application, the focal spot size L1 of the X-ray source 120 satisfies: 50 $\mu$m ≤ L1 ≤ 60 $\mu$m.

In the embodiments of the present application, by limiting the focal spot size L1 of the X-ray source 120 to satisfy: 50 $\mu$m ≤ L1 ≤ 60 $\mu$m, the accuracy and efficiency of the detection can be still further improved while the service life of the X-ray source 120 can be still further prolonged.

According to some embodiments of the present application, the power P of the X-ray source 120 satisfies: 65 watts (W) $\leq$ P $\leq$ 75 W.

In some embodiments of the present application, increasing the X-ray dose requires increasing the power P of the X-ray source 120, which will increase the workload of the X-ray source 120. Meanwhile, increasing the power of the X-ray source 120 results in an increase in the focal spot size of the X-ray source 120, and the larger the focal spot size is, the lower the resolution of the flat panel detector 130 is. If the power P of the X-ray source 120 is reduced, the X-ray dose may be reduced and the detection image on the flat panel detector 130 may be darkened.

In the embodiments of the present application, limiting the power P of the X-ray source 120 to 65 W $\leq$ P $\leq$ 75 W can improve the resolution of the flat panel detector 130 to a certain extent, and meanwhile, can improve the brightness of the detection image to a certain extent, thereby improving the accuracy of the detection.

According to some embodiments of the present application, the power P of the X-ray source 120 satisfies: 68 W $\leq$ P $\leq$ 72 W.

In the embodiments of the present application, further limiting the power P of the X-ray source 120 to 68 W $\leq$ P $\leq$ 72 W can further improve the resolution of the flat panel detector 130, and meanwhile, can further improve the brightness of the detection image, thereby improving the accuracy of the detection device.

According to some embodiments of the present application, an operating voltage V of the X-ray source 120 satisfies: V $\geq$ 130 kilovolts (kV), and/or an operating current I of the X-ray source satisfies: I $\leq$ 500 microamperes ($\mu$A).

In some embodiments of the present application, the maximum X-ray photon energy emitted by the X-ray source 120 is equal to the energy obtained by incident electrons in an accelerating electric field of the ray tube, that is, equal to the electron charge multiplied by the strength of the accelerating electric field. The strength of the accelerating electric field is the magnitude of the tube voltage, that is, the magnitude of the operating voltage V of the X-ray source 120. The higher the operating voltage V is, the higher the energy of the rays generated is, the shorter the wavelength is, and the stronger the ability to penetrate through substances is.

In some embodiments of the present application, the larger the operating current I of the X-ray source 120 is, the more the high-speed electrons are bombarded onto the target per unit time, and the more the rays are emitted by the X-ray source 120, which is equivalent to an increase in the X-ray dose for a certain area and an increase in the brightness of the corresponding image. However, if the operating voltage V or the operating current I of the X-ray source 120 is too large, the focal spot size of the X-ray source 120 will also be too large, which reduces the spatial resolution of the flat panel detector 130 and is not conducive to subsequent image identification and defect determination.

In some embodiments of the present application, the relationship among the intensity i of the rays emitted by the X-ray source 120 and the operating voltage V of the X-ray source 120 and the operating current I of the X-ray source 120 is $i = K \times I \times V^n$, where the coefficient K depends on the high-voltage rectification mode of the X-ray source 120, and the index n is determined by the operating voltage V of the X-ray source 120 and the filtration condition of the X-rays. The intensity i of the rays emitted by the X-ray source 120 is proportional to the operating current I of the X-ray source 120, and is proportional to the N-th power of the operating voltage V of the X-ray source 120.

In some embodiments of the present application, the X-ray attenuation relationship is $i = i_0 e^{-\mu d}$. When X-rays with the intensity of $i_0$ penetrate through a substance with the thickness of d, the intensity I of the emergent rays attenuates exponentially with the thickness; i is the intensity of the emergent X-rays, and $i_0$ is the intensity of the incident X-rays, and $\mu$ is the absorption coefficient of the substance for the X-rays, and d is the distance traveled by the X-rays through the substance.

**In the** embodiments of the present application, by limiting the operating voltage V and the operating current I of the X-ray source 120, the stability and reliability of the X-ray source 120 can be taken into account on the basis that the X-ray dose that meets the requirements is provided. Meanwhile, the X-ray source 120 and the flat panel detector 130 cooperate with each other, and the requirements for the detection precision of the battery 140 to be detected are met, and the efficiency and accuracy of the detection are improved.

According to some embodiments of the present application, the operating voltage V of the X-ray source 120 satisfies: V $\geq$ 150 kV, and/or the operating current I of the X-ray source 120 satisfies: I $\leq$ 400 $\mu$A.

In the embodiments of the present application, by further limiting the operating voltage V or the operating current I of the X-ray source 120, the X-ray dose emitted by the X-ray source 120 is further improved. Meanwhile, the stability and reliability of the X-ray source 120 are further improved, and the efficiency and accuracy of the detection are improved.

According to some embodiments of the present application, the flat panel detector 130 is an amorphous silicon flat panel detector.

In some embodiments of the present application, the amorphous silicon flat panel detector adopts indirect digital X-ray imaging. Its basic structure is that the surface is a layer of scintillator material (cesium iodide or oxysulfide), the next layer is an amorphous silicon-based photodiode circuit, and the bottommost layer is a charge readout circuit. The scintillator located on the surface of the amorphous silicon flat panel detector converts the X-rays into visible light. The amorphous silicon photodiode array beneath the scintillator then converts the visible light into an electric signal, forming stored charges on a capacitor of the photodiode itself. The amount of the stored charges of each pixel is proportional to the intensity of the incident X-rays. Under the action of the control circuit, the stored charges of each pixel are scanned and read out, and a digital signal is output after A/D conversion and transmitted to a computer for image processing, forming an X-ray digital image.

In the embodiments of the present application, the amorphous silicon flat panel detector has high conversion efficiency, wide dynamic range, and strong dose tolerance. Therefore, using the amorphous silicon flat panel detector as the flat panel detector 130 of the battery detection device 100 can improve the detection efficiency and prolong the service life of the battery detection device 100.

According to some embodiments of the present application, the pixel size L2 of the flat panel detector 130 satisfies: $L2 \leq 100 \ \mu m$.

In some embodiments of the present application, the resolution of the flat panel detector 130 is determined by the pixel size L2 of the flat panel detector 130. The smaller the pixel size L2 of the flat panel detector 130 is, the higher the resolution of the flat panel detector 130 is; conversely, the larger the pixel size L2 of the flat panel detector 130 is, the lower the resolution of the flat panel detector 130 is.

In some embodiments of the present application, after the detection image of the battery 140 to be detected is acquired by the battery detection device 100, whether the interior of the battery 140 to be detected is defective can be determined by identifying the detection image by an algorithm. When the detection image is identified by an algorithm, a defect feature in the detection image requires to be identified. The defect feature can be identified by the algorithm only when the imaging range of the defect feature is greater than or equal to 10 pixels. The defect size of the battery 140 to be detected is generally about 500 $\mu m$. When the detection image acquired by the battery detection device 100 is under 2 times magnification, the imaged defect size of the battery 140 to be detected is $500 \ \mu m \times 2 = 1000 \ \mu m$, and the pixel size of the flat panel detector 130 is less than or equal to $1000 \ \mu m / 10 = 100 \ \mu m$. Therefore, the pixel size L2 of the flat panel detector 130 satisfies: $L2 \leq 100 \ \mu m$.

In the embodiments of the present application, by limiting the pixel size L2 of the flat panel detector 130, the requirements for the detection precision of the battery 140 to be detected can be met while the efficiency and accuracy of the detection can also be improved.

According to some embodiments of the present application, the pixel size L2 of the flat panel detector 130 satisfies: $30 \ \mu m \leq L2 \leq 90 \ \mu m$.

In some embodiments of the present application, when the pixel size L2 of the flat panel detector 130 is too small, the amount of light entering a single pixel decreases, the received signal weakens, and the signals between the pixels of the flat panel detector 130 interfere with each other, thereby reducing the signal-to-noise ratio of the detection image produced by the flat panel detector 130. Therefore, the pixel size L2 of the flat panel detector 130 cannot be too small.

In the embodiments of the present application, by further limiting the pixel size L2 of the flat panel detector 130, the requirements for the detection precision of the battery 140 to be detected are met while the efficiency and accuracy of the detection are further improved.

According to some embodiments of the present application, the pixel size L2 of the flat panel detector 130 satisfies: $70 \ \mu m \leq L2 \leq 80 \ \mu m$.

In the embodiments of the present application, by still further limiting the pixel size L2 of the flat panel detector 130, the efficiency and accuracy of the detection are still further improved.

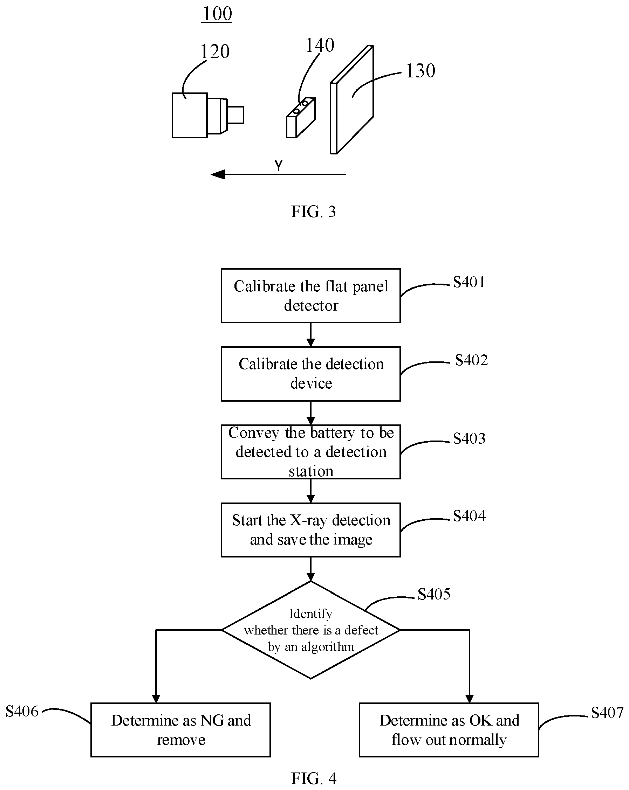

FIG. 3 is a structural schematic view of a battery detection device 100 according to some other embodiments of the present application. Referring to FIG. 1 and FIG. 3, in a first direction (the Y direction in the figure), the distance h1 between an X-ray source 120 and a carrying surface of a carrying assembly 110 and the distance h2 between the carrying surface of the carrying assembly 110 and a flat panel detector 130 satisfy the relationship: $(h1 + h2)/h1 \leq 2.5$, where the first direction is the direction perpendicular to a principal plane of the flat panel detector 130.

In some embodiments of the present application, when the battery detection device 100 is used to detect a battery 140 to be detected, the magnification M of the battery 140 to be detected is associated with the distance h1 between the X-ray source 120 and the carrying surface of the carrying assembly 110 and the distance h2 between the carrying surface of the carrying assembly 110 and the flat panel detector 130, where $M = (h1 + h2)/h1$. Due to the limited imaging area of the flat panel detector 130, when the battery detection device 100 is used to detect the battery 140 to be detected, the magnification M of the battery 140 to be detected generally does not exceed 2.5 times, that is, $(h1 + h2)/h1 \leq 2.5$.

In the embodiments of the present application, the relationship between the distance between the X-ray source 120 and the carrying surface of the carrying assembly 110 and the distance between the carrying surface of the carrying assembly 110 and the flat panel detector 130 is directly related to the magnification M of the battery 140 to be detected. By limiting the relationship between the distance between the X-ray source 120 and the carrying surface of the carrying assembly 110 and the distance between the carrying surface of the carrying assembly 110 and the flat panel detector 130, the detection precision of the battery detection device 100 can better match with the size of the flat panel detector 130 while the accuracy and efficiency of the detection can be improved.

According to some embodiments of the present application, the distance h1 between the X-ray source 120 and the carrying surface and the distance h2 between the carrying surface and the flat panel detector 130 satisfy the relationship: $1.5 \leq (h1 + h2)/h1 \leq 2.0$.

In the embodiments of the present application, by further limiting the relationship between the distance between the X-ray source 120 and the carrying surface of the carrying assembly 110 and the distance between the carrying surface of the carrying assembly 110 and the flat panel detector 130, the detection precision of the battery detection device 100 can further better match with the size of the flat panel detector 130 while the accuracy and efficiency of the detection can be further improved.

The battery detection device of the present application will be further described below with reference to a specific embodiment.

The battery detection device 100 includes a carrying assembly 110, an X-ray source 120, and a flat panel detector 130. The flat panel detector 130 and the X-ray source 120 are respectively located on two sides of the carrying assembly 110. The carrying assembly 110 is configured to carry the battery 140 to be detected. The X-ray source 120 is configured to irradiate the X-rays to the battery 140 to be detected on the carrying assembly 110. The flat panel detector 130 is configured to receive the rays emitted by the X-ray source 120 and penetrating through the battery 140 to be detected. In the direction perpendicular to the principal plane of the flat panel detector 130, the distance h1 between the X-ray source 120 and the carrying surface of the carrying assembly 110 and the distance h2 between the carrying surface of the carrying assembly 110 and the flat panel detector 130 satisfy the relationship:

$$1.5 \leq (h1 + h2)/h1 \leq 2.0.$$

The focal spot size L1 of the X-ray source 120 satisfies: $50 \ \mu m \leq L1 \leq 60 \ \mu m$; the power P of the X-ray source 120 satisfies: $68 \ W \leq P \leq 72 \ W$; the operating voltage V of the X-ray source 120 satisfies: $V \geq 150 \ kV$, and/or the operating current I of the X-ray source 120 satisfies: $I \leq 400 \ \mu A$. The flat panel detector 130 is an amorphous silicon flat panel detector, and the pixel size L2 of the flat panel detector 130 satisfies: $70 \ \mu m \leq L2 \leq 80 \ \mu m$.

FIG. 4 is a flowchart of a detection method of a battery detection device according to some embodiments of the present application. As shown in FIG. 4, the detection method of a battery detection device 100 includes the following steps:

Step S401: calibrating a flat panel detector.

In order to ensure the quality of image detection, the flat panel detector 130 needs to be calibrated before startup. Before calibration, it is necessary to ensure that there are no obstructions between the X-ray source 120 and the flat panel detector 130, including the carrying assembly 110 and various debris. The X-ray source 120 is turned on for bright field image acquisition, and after the bright field image acquisition, the X-ray source 120 is turned off for dark field image acquisition, and 19 images are acquired in each process. The process is repeated three times to calibrate the flat panel detector. After the calibration, the correction template is re-activated.

Step S402: calibrating the detection device.

Before calibration, it is necessary to ensure that there are no batteries 140 to be detected and debris between the X-ray source 120 and the flat panel detector 130. A calibration block equipped with the device is disposed on a detection platform, the scale of the calibration block is adjusted, and the height of a gauge pin mounted on the calibration block is half the height of the battery 140 to be detected. The device is turned off, the X-ray source 120 is turned on, and the gauge pin is moved to the middle of the screen. The relative position of the X-ray source 120 and the flat panel detector 130 is kept consistent with that during the battery detection. A software calibration interface is opened, the diameter of the gauge pin is input, and the software automatically records and saves the magnification.

Step S403: conveying the battery to be detected to a detection station.

The carrying assembly 110 is driven to move to sequentially convey the battery 140 to be detected to the detection position between the X-ray source 120 and the flat panel detector 130, and stops moving to wait for the X-ray to be turned on for detection.

Step S404: starting the X-ray detection and saving the image.

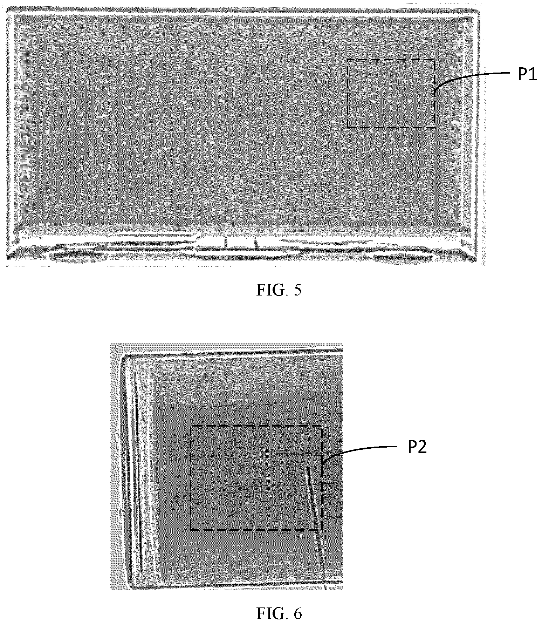

After the operating voltage V and the operating current I of the X-ray source 120 during detection are set, the X-rays are turned on to penetrate through the battery 140 to be detected. The flat panel detector 130 receives the X-rays penetrating through the battery 140 to be detected and converts the X-rays into an image. Then, the processor reads and saves the image. FIG. 5 is a schematic view of a detection image of a battery 140 to be detected according to some embodiments of the present application. FIG. 6 is a schematic view of a detection image of a battery 140 to be detected according to some other embodiments of the present application.

Step S405: identifying whether there is a defect in the image by an algorithm.

By a deep learning algorithm, the metal particle features in the image are captured and identified. If there is a metal particle feature in the image, the step S406 is executed, the image is determined as NG, and the corresponding battery 140 to be detected is automatically removed to prevent the outflow of defective products. Illustratively, as shown in FIG. 5, the metal particle feature exists at the position P1 in the image; FIG. 6 is a schematic view of a detection image of a battery 140 to be detected according to some other embodiments of the present application, and as shown in FIG. 6, the metal particle feature exists at the position P2 in the image. If there is no metal particle feature in the image, the step S407 is executed, the image is determined as OK, and the corresponding battery 140 to be detected flows out normally.

Finally, it should be noted that the above embodiments are only used to illustrate the technical solutions of the present application, rather than limit same. Although the present application has been described in detail with reference to the foregoing embodiments, those of ordinary skill in the art should understand that modifications can still be made to the technical solutions recorded in the foregoing embodiments, or equivalent substitutions to some or all of the technical features can be made. However, such modifications or substitutions do not make the spirit of the corresponding technical solutions deviate from the scope of the technical solutions in the embodiments of the present application, and shall all fall within the scope of claims and specification of the present application. In particular, the technical features mentioned in the embodiments can be combined in any manner, provided that there is no structural conflict. The present application is not limited to the specific embodiments disclosed herein but includes all the technical solutions that fall within the scope of the claims.

## Claims

1. A battery detection device, comprising:

    a carrying assembly, configured to carry a battery to be detected;
    an X-ray source, configured to irradiate X-rays to the battery to be detected on the carrying assembly; and
    a flat panel detector, wherein the flat panel detector and the X-ray source are respectively located on two sides of the carrying assembly, and the flat panel detector is configured to receive rays emitted by the X-ray source and penetrating through the battery to be detected.

2. The battery detection device according to claim 1, wherein a focal spot size L1 of the X-ray source satisfies: $L1 \leq 80\ \mu m$.

3. The battery detection device according to claim 2, wherein the focal spot size L1 of the X-ray source satisfies: $30\ \mu m \leq L1 \leq 80\ \mu m$.

4. The battery detection device according to claim 3, wherein the focal spot size L1 of the X-ray source satisfies: $40\ \mu m \leq L1 \leq 70\ \mu m$.

5. The battery detection device according to claim 4, wherein the focal spot size L1 of the X-ray source satisfies: $50\ \mu m \leq L1 \leq 60\ \mu m$.

6. The battery detection device according to any one of claims 1 to 5, wherein a power P of the X-ray source satisfies: $65\ W \leq P \leq 75\ W$.

7. The battery detection device according to claim 6, wherein the power P of the X-ray source satisfies: $68\ W \leq P \leq 72\ W$.

8. The battery detection device according to any one of claims 1 to 7, wherein an operating voltage V of the X-ray source satisfies: $V \geq 130\ kV$, and/or an operating current I of the X-ray source satisfies: $I \leq 500\ \mu A$.

9. The battery detection device according to claim 8, wherein the operating voltage V of the X-ray source satisfies: $V \geq 150\ kV$, and/or the operating current I of the X-ray source satisfies: $I \leq 400\ \mu A$.

10. The battery detection device according to any one of claims 1 to 9, wherein the flat panel detector is an amorphous silicon flat panel detector.

11. The battery detection device according to any one of claims 1 to 10, wherein a pixel size L2 of the flat panel detector satisfies: $L2 \leq 100\ \mu m$.

12. The battery detection device according to claim 11, wherein the pixel size L2 of the flat panel detector satisfies: $30\ \mu m \leq L2 \leq 90\ \mu m$.

13. The battery detection device according to claim 12, wherein the pixel size L2 of the flat panel detector satisfies: $70\ \mu m \leq L2 \leq 80\ \mu m$.

14. The battery detection device according to any one of claims 1 to 13, wherein in a first direction, a distance h1 between the X-ray source and a carrying surface of the carrying assembly and a distance h2 between the carrying surface of the carrying assembly and the flat panel detector satisfy a relationship:

$$(h1 + h2)/h1 \leq 2.5,$$

wherein the first direction is a direction perpendicular to a principal plane of the flat panel detector.

15. The battery detection device according to claim 14, wherein the distance h1 between the X-ray source and the carrying surface and the distance h2 between the carrying surface and the flat panel detector satisfy a relationship:

$$1.5 \leq (h1 + h2)/h1 \leq 2.0.$$

<u>100</u>

120

h1

140

110

h2

130

FIG. 1

<u>100</u>

L1

120

Da

140

Db

130

FIG. 2

<u>100</u>

120    140

130

Y

FIG. 3

Calibrate the flat panel detector — S401

Calibrate the detection device — S402

Convey the battery to be detected to a detection station — S403

Start the X-ray detection and save the image — S404

Identify whether there is a defect by an algorithm — S405

S406 — Determine as NG and remove

Determine as OK and flow out normally — S407

FIG. 4

FIG. 5

FIG. 6

## INTERNATIONAL SEARCH REPORT

| International application No. |
|---|
| **PCT/CN2023/137468** |

**A.    CLASSIFICATION OF SUBJECT MATTER**

G01N23/04(2018.01)i;  G01N23/083(2018.01)i

According to International Patent Classification (IPC) or to both national classification and IPC

**B.    FIELDS SEARCHED**

Minimum documentation searched (classification system followed by classification symbols)

IPC: G01N

Documentation searched other than minimum documentation to the extent that such documents are included in the fields searched

Electronic data base consulted during the international search (name of data base and, where practicable, search terms used)

CNTXT, CNABS, CNKI, 万方, WANFANG: 电池, X射线, 平板探测器, 焦点, 焦斑, 电流, 电压, 非晶硅, 功率, 像素, 像元; USTXT, WOTXT, EPTXT, VEN, Web of Science: battery, X-ray, flat panel detector, focus, focal spot, current, voltage, amorphous silicon, power, pixel

**C.    DOCUMENTS CONSIDERED TO BE RELEVANT**

| Category* | Citation of document, with indication, where appropriate, of the relevant passages | Relevant to claim No. |
|---|---|---|
| X | CN 218272049 U (SUZHOU LIYING TECHNOLOGY CO., LTD.) 10 January 2023 (2023-01-10)<br>description, paragraphs 27-46, and figures 1-2 | 1-15 |
| X | US 2023056945 A1 (VAREX IMAGING CORP.) 23 February 2023 (2023-02-23)<br>description, paragraphs 18-24, and figure 1 | 1-15 |
| A | CN 208860774 U (YANGZHOU NENGYU TESTING TECHNOLOGY CO., LTD.) 14 May 2019 (2019-05-14)<br>entire document | 1-15 |
| A | CN 115165938 A (CHINA WEAPON SCIENCE ACADEMY NINGBO BRANCH et al.) 11 October 2022 (2022-10-11)<br>entire document | 1-15 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 March 2024** | **08 March 2024** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/137468**

| Patent document cited in search report | | | Publication date (day/month/year) | Patent family member(s) | | | Publication date (day/month/year) |
|---|---|---|---|---|---|---|---|
| CN | 218272049 | U | 10 January 2023 | None | | | |
| US | 2023056945 | A1 | 23 February 2023 | WO | 2023028055 | A1 | 02 March 2023 |
| CN | 208860774 | U | 14 May 2019 | None | | | |
| CN | 115165938 | A | 11 October 2022 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202321704318

- GB 268342011 T